Europäisches Patentamt

European Patent Office

Office européen des brevets

(19)

(11) Veröffentlichungsnummer: **0 181 496**
**B1**

# (12) EUROPÄISCHE PATENTSCHRIFT

(45) Veröffentlichungstag der Patentschrift:
11.01.89

(21) Anmeldenummer: 85112775.3

(22) Anmeldetag: 09.10.85

(51) Int. Cl.⁴: **H01B 12/00**

(54) **Verfahren zur Herstellung eines supraleitenden Drahtes unter Verwendung von Chevrel-Phasen.**

(30) Priorität: 14.11.84 AT 3593/84

(43) Veröffentlichungstag der Anmeldung:
21.05.86 Patentblatt 86/21

(45) Bekanntmachung des Hinweises auf die Patenterteilung:
11.01.89 Patentblatt 89/2

(84) Benannte Vertragsstaaten:
BE CH DE FR GB IT LI NL SE

(56) Entgegenhaltungen:
IEEE TRANSACTIONS ON MAGNETICS, Band MAG-19, Nr. 1, Jänner 1983, New York B. SEEBER, C. ROSSEL, O. FISCHER "Investigation of the Properties of PbMo6S8 Powder Processed Wires" Seiten 402-405
TERNARY SUPERCONDUCTORS, 1981 G.K. SHENOY, B.D. DUNLOP, F.Y. FRADIN, North Holland, New York Seiten 119-124
PROCEEDINGS OF THE 10th PLANSEE-SEMINAR, Band 2, Juni 1981, Reutte B. SEEBER, C. ROSSEL, O. FISCHER "Powder Processed PbMo6S8 Superconductin Wires" Seiten 531-538

(73) Patentinhaber: **METALLWERK PLANSEE GESELLSCHAFT M.B.H., A-6600 Reutte, Tirol(AT)**

(72) Erfinder: **Glätzle, Wolfgang, Dr., Breitenwanger Strasse 7, A-6600 Reutte(AT)**

(74) Vertreter: **Lohnert, Wolfgang, Dr., Metallwerk Plansee GmbH, A-6600 Reutte, Tirol(AT)**

## Beschreibung

Die Erfindung betrifft ein Verfahren zur Herstellung eines ein- oder mehrkernigen supraleitenden Drahtes unter Verwendung eines Metall-Molybdän-Chalkogenides (Chevrel-Phase) in der supraleitenden Phase, insbesondere von $PbMo_6S_8$, wobei die supraleitende Phase oder die Ausgangskomponenten zur Bildung einer solchen Phase vakuumdicht in einen Molybdän-Mantel und dieser vorteilhafterweise in einen Stahlmantel gegeben werden und wobei diese Einheit anschließend durch Warmumformen zu einem supraleitenden Draht verarbeitet wird.

Die Entwicklung supraleitender Drähte und Kabel unter Verwendung binärer Verbindungen (Typ II-Supraleiter), insbesondere von $Nb_3Sn$ und NbTi, hat in den vergangenen Jahren rasche Fortschritte gemacht. Die Technik zur Herstellung von Einfach- und Multifilamentleitern mit räumlich nebeneinander angeordneten supraleitenden und normalleitenden Werkstoffen wurde ständig verfeinert. Für die Herstellung von Multifilamentleitern spielen die Verfahrensschritte des Warm- und Kaltumformens, z.B. des Strangpressens und Drahtziehens, eine wesentliche Rolle (DE-AS 2 516 745, DE-AS 1 945 640). Dabei hat man bezüglich der drei kritischen supraleitenden Größen: Temperatur, Stromdichte und Magnetfeld kaum mehr nennenswert erhöhbare Grenzbereiche erreicht.

Weitere Steigerungsmöglichkeiten, zumindest für die eine oder andere der kritischen supraleitenden Größen, sind durch den Übergang von binären auf ternäre supraleitende Phasen möglich. Mit dem Übergang zu ternären Systemen, z.B. in Form von Chevrel-Phasen (Metall-Mo-Chalkogenide), wird die Variationsmöglichkeit derjenigen metallurgischen Parameter erhöht, welche für die Supraleitfähigkeit wichtig sind. Gleichzeitig aber nehmen die Schwierigkeiten der Verarbeitbarkeit für ternärer Systeme sprunghaft zu.

Entsprechend sind auch die wenigen Veröffentlichungen über die Herstellbarkeit von Supraleitern unter Verwendung der Chevrel-Phasen wenig ermutigend. Der veröffentlichte Bericht eines Arbeitskreises "Research opportunities in superconductivity", veranstaltet am 22. und 23.08.1983 in Copper-Mountain, Colorado, USA, besagt auf Seite 16: "Viele neue Werkstoffe, z.B. $PbMo_6S_8$, können nicht unter Anwendung der Strangpreß- und Drahtziehtechnik hergestellt werden, welche für Nb-Ti und $Nb_3Sn$ so erfolgreich waren." In einem Aufsatz über die Chevrel-Phasen als neue Gruppen von Hochfeld-Supraleitern, veröffentlicht in der Zeitschrift Metall, Jahrgang 35, Heft 4, April 1981, ist auf Seite 289, Spalte 3 zu lesen: "Leider ist bisher die Herstellung von Drähten ternärer Molybdän-Chalkogenide mit technologisch interessanter Stromtragfähigkeit aufgrund ihrer schlechten metallurgischen Eigenschaften nicht gelungen."

Die Probleme bei der Verarbeitung von Chevrel-Phasen zu supraleitenden Kabeln, insbesondere von $PbMo_6S_8$, sind mannigfaltig. Der metallische Werkstoff $PbMo_6S_8$ ist sehr spröde und brüchig. Er tritt daher stets nur als pulverförmige heterogene Phase auf. Die Chevrel-Phasen zeigen neben ihrer geringen Duktilität eine hohe Empfindlichkeit gegen Sauerstoff und Stickstoff, aber auch gegen andere metallische Elemente, insbesondere Fe, Co, Ni, Cr. Die Chevrel-Phasen sind bei der Herstellung von supraleitenden Drähten und Kabeln entsprechend zu schützen, und zwar sowohl gegen direkte Kontamination als auch gegen Interdiffusion durch Hüllenwerkstoffe bei den hohen, in der Praxis erforderlichen Verarbeitungstemperaturen. Die Chevrel-Phasen in supraleitenden Drähten und Kabeln müssen wie alle Supraleiter mechanischen Beanspruchungen standhalten, d.h., sie müssen die durch geeignete Herstellverfahren erreichten Materialdichten auch beim Biegen der Leiter zu Spulen und beim Auftreten extremer Zug- und Druckkräfte infolge der großen magnetischen Kräfte in einer supraleitenden Spule beibehalten. Supraleitende Drähte unter Verwendung von Chevrel-Phasen müssen auch "kryogen stabilisiert" werden, d.h., die supraleitende Phase muß in gutem thermischen und elektrischen Kontakt mit einer genügenden Menge hochleitfähigen normalleitenden Metalls sein, das im Fall eines lokalen Zusammenbruchs der Supraleitfähigkeit den Strom vorübergehend übernehmen kann und die auftretende Joule'sche Wärme an das Kühlmedium Helium abführt, ohne daß eine unzulässige Temperaturerhöhung des Leiters auftritt (Metall, Jahrgang 35, Heft 4, Seite 292).

Es sind einzelne Versuche bekannt, supraleitende Drähte unter Verwendung von Chevrel-Phasen herzustellen. So wurde in einem Fertigungsversuch das supraleitende Material $PbMo_6S_8$ bzw. geeignete Ausgangskomponenten in ein Molybdän- und alternativ in ein Tantalrohr vakuumdicht eingebracht. Das Mo- oder Tantal-Rohr wurde anschließend in ein Rohr aus rostfreiem Stahl eingeschweißt, um das innere Rohr bei der Weiterverarbeitung gegen Oxidation zu schützen. Die Weiterverarbeitung erfolgte in zwei Schritten durch Warmziehen bei 750° bzw. 600°C und dazwischenliegendes Tempern bei 850°C. Das Ergebnis war jedoch wenig zufriedenstellend. Die erwarteten kritischen Stromdichten und Magnetfelder konnten nicht erreicht werden. Als Grund für die unbefriedigenden Ergebnisse wurde vermutet, daß die Molybdän-Rohre nach der Verarbeitung durch Hochtemperaturziehen möglicherweise brüchig geworden waren und daß durch diese Bruchstellen Eisen, Chrom und/oder Nickel aus dem Stahlmantel in die Chevrel-Phase diffundiert sind, was zu einer Zerstörung der Chevrel-Phase führte (Seeber, B., Rossel, C., Fischer, O.: "Proc. of the International Conference on Ternary Superconductors", Lake Geneva, Wisconsin 1980. Seeber, B., Rossel, C., Fischer, O., Glätzle, W.: "Investigation of the Properties of $PbMo_6S_8$ Powder Processed Wires" in IEEE Transactions on Magnetics, Vol MAG-19, Nr. 1, 1983, Seiten 402 – 405, insbesondere Seite 402 und Seite 405, linke Spalte).

Aufgabe vorliegender Erfindung ist es daher, technisch verarbeitbare supraleitende Drähte unter Verwendung supraleitender Metall-Molybdän-Chalkogenide (Chevrel-Phasen) herzustellen, bei denen die Nachteile bekannter Ausführungen nicht auftreten. Dabei geht es einmal darum, die Chevrel-Phase bei der Drahtherstellung gegen Kontamination und Interdiffusion von die Chevrel-Phase zerstörenden Elementen zu schützen. Durch das zu wählende Herstellungsverfahren ist die Chevrel-Phase so dicht zu verpressen, daß sich die theoretisch erreichbaren kritischen Supraleitergrößen dauerhaft einstellen, daß sich die vom Fachmann erwünschte Struktur der Magnetfluß-Schläuche bildet und eine für die Weiterverarbeitung zu supraleitenden Kabeln und Spulen ausreichende mechanische Festigkeit gewährleistet ist.

Diese Aufgabe wird gemäß dem Verfahren nach anspruch 1 gelöst.

Nach einer bevorzugten Ausführung der Erfindung werden die Ausgangskomponenten zur Bildung einer supraleitenden Phase, und zwar $Mo_2S_3$ oder $MoS_2$, Mo und PbS in stöchiometrischem Verhältnis von $PbMo_6S_8$ in einen Molybdän-Mantel eingebracht. Die Umwandlung zur Chevrel-Phase erfolgt im Zuge der Drahtherstellung durch Warmumformung.

Nach einer anderen bevorzugten Ausführung wird eine supraleitende Phase von nicht stöchiometrischer Zusammensetzung, vorzugsweise als $PbMo_{6,35}S_8$ verwendet.

Nach einer weiteren bevorzugten Ausführung des Verfahrens wird der Chevrel-Phase Gallium-Sulfid, vorzugsweise im Phasenverhältnis $PbGa_{0,25}Mo_6S_8$, zugegeben.

Ein weiteres bevorzugtes Verfahren zur Herstellung supraleitenden Drahtes besteht darin, daß ein Mehrkernleiter hergestellt wird, indem die supraleitende Phase bzw. die Ausgangskomponenten zur Bildung einer solchen Phase in einen als Mantel dienenden Molybdän-Block mit einer Mehrzahl von zylinderförmigen Ausnehmungen eingebracht wird.

Schließlich besteht ein bevorzugtes Verfahren darin, die pulverförmige supraleitende Phase vor dem Einbringen in den Molybdän-Mantel durch kaltisostatisches Pressen und wahlweise durch anschließendes mechanisches Nachbearbeiten in die gewünschte geometrische Form zu bringen.

Durch dieses Verfahren lassen sich erstmals supraleitende Drähte unter Verwendung von Chevrel-Phasen herstellen, welche technisch weiterverarbeitbar sind, z.B. als supraleitende Spulen, und in etwa die theoretisch erwarteten und bisher nur im Labormaßstab erreichten kritischen supraleitenden Eigenschaften aufweisen. Im Unterschied zur Verarbeitung von Typ II-Supraleitern, wo für technische Anwendungen zufriedenstellende ein- oder mehrkernige supraleitende Drähte mittels vieler unterschiedlicher Verfahren erreichbar sind und die Drähte vorteilhafterweise mittels der Strangpreßtechnik zu Multifilamentleitern verarbeitet werden, zeigt sich im Fall vorliegender Erfindung, daß erst durch das Strangpressen der Chevrel-Phasen unter den in dieser Erfindung genannten Bedingungen überhaupt die Herstellung eines technisch weiterverarbeitbaren, supraleitenden Drahtes mit Chevrel-Phasen möglich wird. Erst der Strangpreßvorgang im angegebenen Temperaturbereich zwischen 1000° und 1600°C sowie bei den angegebenen Querschnittsverjüngungen erzeugt die Größenordnung an Umformkräften, welche ein Verdichten der Chevrel-Phase zu Supraleitern mit zufriedenstellenden kritischen Stromdichten ermöglicht. Dabei gilt für die angegebenen Grenzen der Strangpreßtemperatur, daß bei Temperaturen unter 1000°C keine ausreichenden Verdichtungskräfte aufgebracht werden und sich oberhalb von 1600°C die Chevrel-Phase zersetzt. Für den Fall, daß die Chevrel-Phase sowohl in einen Molybdän-Mantel als auch anschließend in einen Stahl-Mantel eingebracht wird, so liegt aufgrund der Stahl-Eigenschaften die Temperatur-Obergrenze der Verarbeitbarkeit bei ca. 1300°C.

Der Molybdän-Mantel bzw. der Molybdän- plus Stahl-Mantel um die Chevrel-Phase dient einmal zum Schutz gegen Kontamination und als Diffusionsbarriere. Er dient aber auch als Hülle, welche beim Abkühlen nach der Warmumformung auf den supraleitenden Kern aufschrumpft und damit die dauerhafte Beibehaltung derjenigen Verdichtung des supraleitenden Materials gewährleistet, welche diesem während des Strangpressens gegeben wurde.

Allein durch Ziehen der Einheit aus supraleitender Chevrel-Phase und Molybdän- bzw. Molybdän- und Stahl-Mantel lassen sich keine ausreichenden Verdichtungen zur Erzeugung einer beständigen supraleitenden Phase erzielen.

Für den Fall, daß sowohl ein erster Mantel aus Molybdän als auch ein zweiter Mantel aus Stahl verwendet wird, dient der Molybdän-Mantel in erster Linie als Diffusionssperre, vor allem gegen Eisen und andere im Stahl enthaltene Metalle, welche Chevrel-Phasen schon beim Vorliegen kleinster Mengen zerstören.

Früher waren als gleichwertige Metalle für die Diffusionsbarriere gegen Chevrel-Phase neben Molybdän vor allem auch Tantal, Silber, Kupfer und Aluminium genannt worden. Nunmehr zeigt sich, daß die übrigen genannten Metalle entweder nicht die notwendigerweise erforderlichen hohen Umformtemperaturen beim Strangpressen zulassen, nicht tolerierbare Reaktionen mit den Chevrel-Phasen zeigen, und/oder nicht die benötigte mechanische Festigkeit als Hüllenwerkstoff aufweisen.

Die von einem Mo-Mantel eingeschlossene supraleitende Phase kann neben Bereichen mit Chevrel-Phase auch Bereiche mit anderen Elementen und Verbindungen aufweisen.

Das erfinderische Verfahren wird nachfolgend anhand eines Beispieles näher beschrieben.

Die pulverförmigen Ausgangskomponenten zur Bildung der Chevrel-Phasen werden durch Reaktion der hochreinen Ausgangselemente erhalten, z.B. $Mo + 2S = MoS_2$. Die Ausgangskomponenten für die supraleitende Phase werden im nichtstöchiometrischen Verhältnis und unter Zusatz von Gallium-Sulfid auf eine Mischung der Zusammensetzung $PbGa_{0,25}Mo_6S_8$ gebracht. Es ist bekannt, daß durch die Bildung einer Chevrel-Phase mit nichtstöchiometrischen Verhältnissen und insbesondere durch den Zusatz von Gallium-Sulfid die Stromtragfähigkeit bzw. die kritische Stromdichte des Supraleiters wesentlich erhöht werden kann.

In einem nächsten Verfahrensschritt wird die Mischung gemahlen, so daß ein Pulver von mittlerer

Korngröße kleiner 1 μm entsteht. Die so erhaltene Pulvermischung wird im Preßschlauch zu Bolzen von 60 mm Durchmesser kaltisostatisch gepreßt. Der gepreßte Bolzen wird gegebenenfalls abgedreht, um möglichst exakt in eine zylindrische Molybdän-Hülle von einigen mm Wandstärke eingepaßt werden zu können. Der in den Mantel eingebrachte Bolzen wird im Vakuum entgast und dann unter Gasunterdruck in den Mantel eingeschweißt. Die so erhaltene Einheit wird in einen Stahl-Mantel eingebracht und im Unterdruck in diesen eingeschweißt.

Diese so gewonnene Einheit wird in einem ersten Umformvorgang stranggepreßt. Dabei wird der Bolzen bei einer Temperatur von 1300°C zu einem Formling von 18 mm Durchmesser extrudiert. Die weitere Verarbeitung der Einheit erfolgt durch Hämmern bei ca. 1000°C sowie mittels einer Vielzahl von Ziehvorgängen, bis schließlich ein Draht von 0,15 mm Durchmesser erreicht ist. Die Reaktion der Ausgangskomponenten zur Chevrel-Phase erfolgt unter den bekannten Umwandlungsbedingungen im Mo-Mantel im Zuge der Drahtherstellung.

Die Ausmessung derartig gefertigter Drähte unter supraleitenden Bedingungen ergab Werte für die kritischen supraleitenden Größen, die sich mit den bisher für Typ II-Supraleiter gemessenen Werte vergleichen lassen, bzw. diese in Einzelwerten übertreffen. Das gilt auch für Drähte, die analog den Verhältnissen bei der Spulenwicklung gebogen bzw. mechanisch beansprucht wurden.

## Patentansprüche

1. Verfahren zur Herstellung eines supraleitenden Drahtes unter Verwendung eines Metall-Molybdän-Chalkogenides (Chevrel-Phase) in der supraleitenden Phase, insbesondere von Pb-$Mo_6S_8$, wobei die supraleitende Phase oder die Ausgangskomponenten zur Bildung einer solchen Phase vakuumdicht in einen Molybdän-Mantel und dieser vorteilhafterweise in einen Stahlmantel eingebracht und diese Einheit anschließend durch Warmumformen in mehreren Verfahrensschritten zu einem supraleitenden Draht verarbeitet wird, dadurch gekennzeichnet, daß die Einheit in einem ersten Verfahrensschritt bei Temperaturen zwischen 1000° und 1600°C und Querschnittsverjüngungen größer 1:10 stranggepreßt wird und anschließend in einer Mehrzahl von Schritten durch nochmaliges Strangpressen und/oder Warmziehen weiterverformt wird und daß als Ausgangsmaterial eine pulverförmige supraleitende Phase bzw. die Ausgangskomponenten zur Bildung der Phase mit einer mittleren Korngröße kleiner als 1 μm verwendet wird.

2. Verfahren zur Herstellung eines supraleitenden Drahtes nach Anspruch 1, dadurch gekennzeichnet, daß als Ausgangskomponenten zur Bildung einer supraleitenden Phase $Mo_2S_3$ oder $MoS_2$ sowie Mo und PbS in stöchiometrischem Verhältnis von $PbMo_6S_8$ in einen Molybdän-Mantel eingebracht werden.

3. Verfahren zur Herstellung eines supraleitenden Drahtes nach Anspruch 1, dadurch gekennzeichnet, daß als Ausgangskomponenten zur Bildung einer supraleitenden Phase von nicht stöchiometrischer Zusammensetzung, vorzugsweise als $PbMo_{6,35}S_8$, die Komponenten $Mo_2S_3$ oder $MoS_2$ sowie Mo und PbS verwendet werden.

4. Verfahren zur Herstellung eines supraleitenden Drahtes nach einem der Ansprüche 1 bis 3, dadurch gekennzeichnet, daß der Chevrel-Phase Gallium-Sulfid, vorzugsweise im Phasenverhältnis $PbGa_{0,25}Mo_6S_8$, zugegeben wird.

5. Verfahren zur Herstellung eines supraleitenden Drahtes nach einem der Ansprüche 1 bis 4, dadurch gekennzeichnet, daß ein Mehrkernleiter hergestellt wird, indem die supraleitende Phase bzw. die Ausgangskomponenten zur Bildung einer solchen Phase in einen als Mantel dienenden Mo-Block mit einer Mehrzahl von zylinderförmigen Ausnehmungen eingebracht wird.

6. Verfahren zur Herstellung eines supraleitenden Drahtes nach einem der Ansprüche 1 bis 5, dadurch gekennzeichnet, daß die pulverförmige supraleitende Phase vor dem Einbringen in den Molybdän-Mantel durch kaltisostatisches Pressen und wahlweise durch anschließendes mechanisches Nachbearbeiten in die gewünschte geometrische Form gebracht wird.

## Claims

1. A process for producing a superconducting wire using a metal-moybdenum chalcogenide (chevrel phase) especially $PbMo_6S_8$ for the superconductive phase by vacuum-tight loading the superconductive phase or the initial components for forming the superconductive phase into a molybdenum shell and loading said molybdenum shell advantageously into a steel jacket, and subsequently hot shaping said unit in several process steps to a superconducting wire characterized in extruding said unit in a first process step at temperatures between 1000° and 1600°C, reducing the cross sectional dimension to less than on tenth its original size and subsequently subjecting said unit to additional extruding and/or hot drawing in several using as initial material a powdered superconductive phase respectively the initials components for forming said phase of an average grain size of less than 1 μm.

2. A process for producing a superconducting wire according to claim 1, characterized in loading as initial components for forming the superconductive phase $Mo_2S_3$ or $MoS_2$, further Mo and PbS at a stoichiometric ratio of $PbMo_6S_8$ into said molybdenum shell.

3. A process for producing a superconducting wire according to claim 1, characterized in using the components $Mo_2S_3$ or $MoS_2$, further Mo and PbS as initial components for forming a superconductive phase in non-stoichiometric ratio, preferably as $PbMo_{6,35}S_8$.

4. A process for producing a superconducting wire according to one of the claims 1 to 3, characterized in adding gallium sulfide, preferably in a phase ratio $PbGa_{0,25}Mo_6S_8$ to the chevrel-phase.

5. A process for producing a superconducting wire according to one of the claims 1 to 4, characterized in manufacturing a multi-core conductor by loading the superconductive phase, respectively the initial components for forming said phase into a Mo-block serving as shell and having a plurality of cylinder-shaped recesses.

6. A process for producing a superconducting wire according to one of the claims 1 to 5, characterized in shaping the powdered superconductive phase by cold isostatic pressing and optionally subsequent mechanical afterworking into the desired geometric form, prior to loading into said molybdenum shell.

**Revendications**

1. Procédé de fabrication d'un fil supraconducteur en utilisant un chalcogénure de molybdène-métal (phase de Chevrel) dans la phase supraconductrice, notamment en utilisant du $PbMo_6S_8$, la phase supraconductrice ou les composants initiaux pour former une telle phase étant placés, de manière étanche au vide, dans une enveloppe en molybdène et celle-ci étant avantageusement placée dans une enveloppe en acier, cette unité étant ensuite transformée, par formage à chaud en plusieurs étapes de procédé, en fil supraconducteur, caractérisé par le fait qu'au cours d'une première étape de procédé, on extrude l'unité à des températures comprises entre 1000° et 1600°C et avec des réductions de section droite supérieures à 1:10, puis, au cours de plusieurs étapes, on la façonne encore, par extrusion et/ou tréfilage à chaud, et par le fait que l'on utilise, comme matière de départ, une phase supraconductrice pulvérulente et/ou les composants initiaux pour former cette phase, ayant une grosseur de grain moyenne inférieure à 1 μm.

2. Procédé de fabrication d'un fil supraconducteur selon la revendication 1, caractérisé par le fait que l'on place dans une enveloppe en molybdène, en tant que composants initiaux pour former une phase supraconductrice, $Mo_2S_3$ ou $MoS_2$ ainsi que Mo et PbS, dans les proportions stoechiométriques de $PbMo_6S_8$.

3. Procédé de fabrication d'un fil supraconducteur selon la revendication 1, caractérisé par le fait que l'on utilise, comme composants initiaux pour former une phase supraconductrice de composition non stoechiométrique, de préférence telle que $PbMo_{6,35}S_8$, les composants $Mo_2S_3$ ou $MoS_2$, ainsi que Mo et PbS.

4. Procédé de fabrication d'un fil supraconducteur selon l'une des revendications 1 à 3, caractérisé par le fait que l'on ajoute à la phase de Chevrel du sulfure de gallium, de préférence dans la proportion de phases $PbGa_{0,25}Mo_6S_8$.

5. Procédé de fabrication d'un fil supraconducteur selon l'une des revendications 1 à 4, caractérisé par le fait que l'on fabrique un conducteur à plusieurs âmes en plaçant à cette fin la phase supraconductrice, et/ou les composants initiaux pour former une telle phase, dans un bloc de molybdène servant d'enveloppe, doté de plusieurs évidements cylindriques.

6. Procédé de fabrication d'un fil supraconducteur selon l'une des revendications 1 à 5, caractérisé par le fait que l'on met la phase supraconductrice pulvérulente à la forme géométrique désirée, par compression isostatique à froid éventuellement suivie d'un usinage mécanique complémentaire, avant de la placer dans l'enveloppe en molybdène.